# EUROPEAN PATENT SPECIFICATION

(11) **EP 4 291 847 B1**
(45) Date of publication and mention of the grant of the patent: **22.04.2026**
(21) Application number: 22705069.7
(22) Date of filing: 09.02.2022
(51) Int. Cl.: F28D 15/02, F28F 3/12, H01L 23/427, F28F 3/04

(54) **HEAT DISSIPATION APPARATUS**
WÄRMEABLEITUNGSVORRICHTUNG
APPAREIL DE DISSIPATION DE CHALEUR

(30) Priority: 15.02.2021 FI 20215154
(43) Date of publication of application: 20.12.2023
(73) Proprietor: CooliBlade Oy, 90620 Oulu (FI)
(72) Inventor: PENTIKÄINEN, Vesa, 90620 Oulu (FI); JOKELAINEN, Kimmo, 90620 Oulu (FI)
(74) Representative: Laine IP Oy
(86) International application number: PCT/FI2022/050079
(87) International publication number: WO 2022/171931

(56) References cited:
- EP-A1- 3 144 771
- WO-A1-2004/106822
- WO-A1-2010/150064
- CN-A- 110 430 724
- US-A1- 2003 121 643
- US-A1- 2006 096 740

## Description

### FIELD

The present disclosure relates to the cooling of heat sources, particularly electric or optical components, particularly high power electric or optical components.

### BACKGROUND

The cooling of electric components, such as microprocessors, LEDs, IGBT modules, etc., is conventionally based on attaching a heat transfer element to physical and thermally conducting connection to the component. A typical such heat transfer element comprises a heat sink that provides for a large heat dissipation area for dissipating heat away from the component to the ambient. Also, forced flow liquid cooled heat transfer elements are known, such as radiators.

There is also known to provide a heat sink with inner cavities so as to device a heat pipe inside the heat sink for facilitating efficient heat distribution across the heat sink. CN 103307579 B, for example, discloses such a solution, wherein an LED component is attached to the bottom of a vertical heat sink with radially extending fins and a hollow cylindrical core acting as a heat pipe for leading heat to the heat sink. While effective, the heat dissipation apparatus of CN 103307579 B may be considered relatively rigid in terms of design and application because the heat sink must be located in a particular manner in respect to the heat source, i.e. longitudinally in series with the heat source. Such a restriction will prevent flush installation with a receiving structure, for example The preamble of claim 1 is based on prior art document CN 110 430 724 A.

There remains, however, the need to further develop the cooling of electric components with heat dissipation apparatuses, which offer not only effective heat transfer but also flexibility in terms of design, or at least to provide the public with a useful alternative.

### SUMMARY

The invention is defined by the features of the independent claims. Some specific embodiments are defined in the dependent claims.

According to a first aspect of the present disclosure, there is provided a heat dissipation apparatus comprising a block and a plurality of closed flow cavities, which are formed, at least in part, into the block. The flow cavities perform a heat pipe cycle, when provided with a phase change heat transfer fluid and heat from a heat source. The flow cavities have, at least in part, a rotationally non-symmetrical cross-sectional shape. The apparatus also includes at least one heat dissipation section which extends from the block. The apparatus may include a closing element for closing the flow cavity and for receiving a heat source at a mounting zone and/or the body may include said mounting zone. Several heat sources may be received at the mounting zone into alignment with the respective plurality of flow cavities. The plurality of flow cavities have different widths for assigning different heat dissipating resources for different heat sources.

One or more embodiments may include one or more features from the following list:
- the flow cavity has, at least in part, a generally quadrilateral cross-sectional shape;
- the flow cavity comprises a proximal section, which is closest to a mounting point for the heat source;
- the proximal section features the rotationally non-symmetrical cross-sectional shape;
- the heat dissipation section comprises a base and a plurality of fins extending from the base;
- the base extends from the block;
- the flow cavity comprises a distal section, which is connected to the proximal section;
- the distal section is provided to the base
- the distal section is configured to spread the heat from the proximal section along the base;
- the distal section comprises a network of interconnected sub-cavities which is connected to the proximal section;
- the rotationally non-symmetrical cross-sectional shape extends more in one dimension than in an orthogonal other dimension by one order of magnitude or more;
- the rotationally non-symmetrical section of the flow cavity has a length in one Cartesian dimension, width in a second Cartesian dimension, and depth in third Cartesian dimension;
- the rotationally non-symmetrical section of the flow cavity comprises an evaporation zone;
- the rotationally non-symmetrical section of the flow cavity comprises a condensation zone distinguished or spaced apart from the evaporation zone;
- the rotationally non-symmetrical section of the flow cavity is configured to perform the heat pipe cycle between the evaporation zone and the condensation zone;
- the block is configured to receive the heat source directly or indirectly at the evaporation zone;
- the heat dissipation section forms the condensation zone;
- the heat dissipation apparatus comprises a closing element which is attached to the block for closing the flow cavity;
- the closing element comprises a mounting zone for receiving thereto the heat source;
- the block comprises a mounting zone for receiving thereto the heat source;
- the closing element and the block both comprise a shared mounting zone for receiving thereto the heat source;
- the mounting zone of the closing element is aligned with the evaporation zone of the flow cavity;
- the heat dissipation apparatus comprises a plurality of such flow cavities which are spaced apart by an intermediate wall of the block between said flow cavities;
- the mounting zone is configured to receive a respective plurality of heat sources;
- the plurality of heat sources is aligned with the plurality of flow cavities;
- the first and second flow cavity have different widths for assigning different heat dissipating resources for different heat sources.
- the rotationally non-symmetrical section of the flow cavity or one or more of the flow cavities comprises an isthmus for dividing the flow cavity into branches;
- the heat dissipation section comprises a plurality of fins attached, e.g. welded, or formed, e.g. extruded, to the block or closing element or both to the block and closing element;
- the heat dissipation section is spaced apart from the mounting zone,
- the mounting zone is on the opposite side of the block than the heat dissipation section.

Considerable benefits are gained with aid of the novel proposition. The novel design of the flow cavity inside the heat dissipation apparatus provides for new possibilities to design the cooling of heat sources by expanding freedom of design without compromising the heat transfer properties of conventional heat dissipation solutions. The present proposal exploits the very effective concept of a heat pipe cycle for transferring heat from a heat source to a heat sink for dissipation. In addition, the non-tubular flow cavity extending from the heat source to the heat sink enables new degrees in freedom. The heat sink may, for example, be located relatively far from the heat source and/or on a different side of the block than the heat source. Heat may also be transferred past components that do not require extra cooling. For example, power electronics components, which require extra cooling, and control componentry, which may not require extra cooling, may be mounted on a same carrying block by transferring the heat of the power electronics past the control componentry for dissipation with a heat sink. The present solution therefore allows for design freedom to mount several different components on a single host even if not all of the components require extra cooling. In addition, the novel shape of the flow cavity helps to spread the heat across a relatively large dissipation area.

### BRIEF DESCRIPTION OF THE DRAWINGS

In the following certain embodiments of the invention are described in greater detail with reference to the accompanying drawings, in which:
- FIGURE 1: illustrates a perspective bottom view of a heat dissipation apparatus in accordance with at least some embodiments of the present invention;
- FIGURE 2: illustrates an exploded view of the heat dissipation apparatus of FIGURE 2;
- FIGURE 3: illustrates a perspective bottom view of a heat dissipation apparatus with two heat dissipating sections in accordance with at least some embodiments of the present invention;
- FIGURE 4: illustrates an exploded view of the heat dissipation apparatus of FIGURE 3;
- FIGURE 5: illustrates a perspective bottom view of a heat dissipation apparatus with two flow cavities in accordance with at least some embodiments of the present invention;
- FIGURE 6: illustrates an exploded view of the heat dissipation apparatus of FIGURE 5;
- FIGURE 7: illustrates a perspective bottom view of a heat dissipation apparatus with a heat dissipation section distanced from the heat source in accordance with at least some embodiments of the present invention;
- FIGURE 8: illustrates an exploded view of the heat dissipation apparatus of FIGURE 7;
- FIGURE 9: illustrates a perspective top view of a heat dissipation apparatus with two flow cavities, a heat dissipation section distanced from two heat sources, and with additional componentry mounted on the closing element in accordance with at least some embodiments of the present invention;
- FIGURE 10: illustrates an exploded view of the heat dissipation apparatus of FIGURE 9;
- FIGURE 11: illustrates a perspective bottom view of the heat dissipation apparatus of FIGURE 9;
- FIGURE 12: illustrates an exploded view of the heat dissipation apparatus of FIGURE 11;
- FIGURE 13: illustrates a perspective bottom view of a heat dissipation apparatus with a section of the flow channel integrated into the base of the heat sink in accordance with at least some embodiments of the present invention;
- FIGURE 14: illustrates a partially sectioned top perspective view of the heat dissipation apparatus of FIGURE 13, and
- FIGURE 15: illustrates a partially sectioned top perspective view of a modified embodiment of the heat dissipation apparatus of FIGURE 13.

### EMBODIMENTS

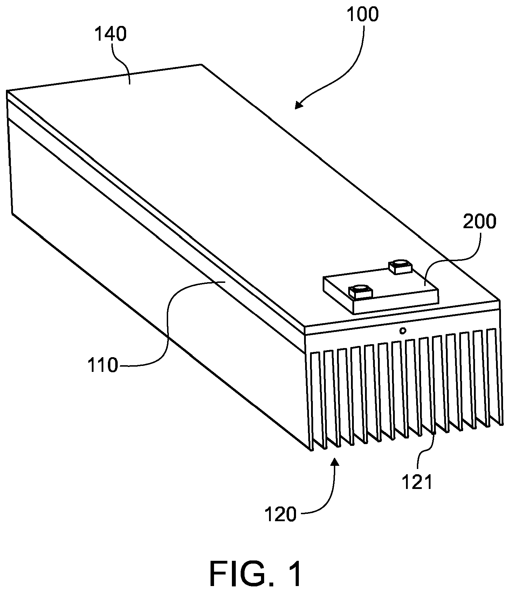

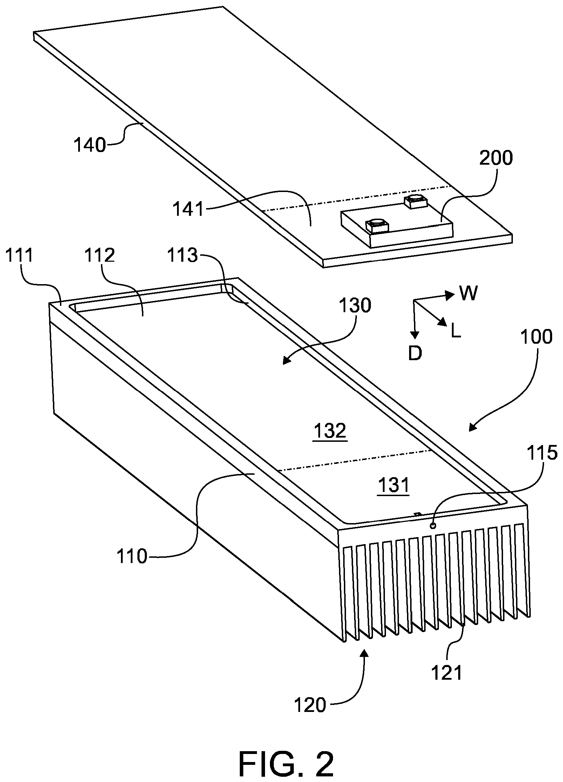

FIGURES 1 and 2 illustrates a simple embodiment of the present invention. The exemplary heat dissipation apparatus 100 is used for dissipating heat produced by a heat source 200 by exploiting a heat pipe effect inside the heat dissipation apparatus 100 for transferring heat to and spreading it across a heat dissipation section 120. The heat dissipation apparatus 100 has three basic components: a block 110, a heat dissipation section 120 and a closing element 140. The heat dissipation apparatus 100 is therefore basically a modified heat sink. The heat source 200 may be a power electronics component, a processor, an artificial illuminating component, or any conventional component producing great quantities of heat.

The block 110 may have a generally boxy form with a flow cavity 130 formed therein. The illustrated embodiments show a generally quadrilateral flow cavity 130 but shape of the flow cavity may be varied. For example, the flow cavity 130 may assume curved shapes or a shape having fewer or more than four sides. Additionally or alternatively, the depth of the flow cavity may vary along the flow cavity and between different flow cavity designs. Additionally or alternatively, the corners of the flow cavity 130 may be rounded, chamfered, or otherwise modified. The block 110 may be cast or extruded from a thermally conducting material, such as steel, aluminium, a metal alloy, etc. In the example of FIGURES 1 and 2, the block 110 exhibits an elongated and relatively flat quadrangular shape. The flow cavity 130 is formed into the block 110 with a recess 112 made into the block 110 by e.g. milling, casting, or cold forging, or any combination of these. The recess 112 has a relatively flat surface deviated from the base material of the block 110. The block 110 has a peripheral edge 111 surrounding the recess 112 and connected there to by a transition 113 which is a wall around the recess 112.

The flow cavity 130 according to the embodiments described herein has a fully or partially rotationally non-symmetrical cross-sectional shape.

The flow cavity 130 is formed into a volume defined by the recess 112 at one end, the transition 113 on the sides, and the closing element 140 at the other end. The closing element 140 may take the form of a simple lid connecting to the block 110. More specifically, the closing element 140 attaches to the peripheral edge 111 of the block 110 closing the flow cavity 130. The closing element 140 may match the dimensions of the block 110. The closing element 140 may be a component of the apparatus or it may be an integral component of a host device, such as a wall of an electric power conversion device, e.g. an AC drive or a frequency converter, a distribution substation, a telecommunications server, or a cellular network base station. With the closing element 140 in place the flow cavity 130 exhibits a width W in one Cartesian dimension, a length L in a second Cartesian dimension, and a depth D in a third Cartesian dimension. The closing element 140 may feature a recess to increase the depth of the flow cavity 130 (not illustrated in the FIGURES). It is to be noted that, compared to conventional heat transfer solutions between a heat source 200 and heat dissipation section 120, the flow cavity 130 exhibits a rotationally non-symmetrical cross-sectional shape. In the present context the cross-sectional shape is observed across the length L, width W, depth D, or both any combination of these dimensions of the flow cavity 130. The flow cavity 130 is considerably shallow. Indeed the length L and width W may at least twice as large as the depth D, preferably five times or more than five times the depth D, more preferably ten times or more than ten times the depth D. The flow cavity 130 performs a heat pipe cycle when provided with a phase change heat transfer fluid and heat from a heat source 200. The heat transfer fluid may be provided into the flow cavity 130 through a port 115 on the block 110 which may be sealed after filling with a simple plug, for example.

In the present disclosure the heat pipe cycle refers generally to a physical phenomenon in which a heat transfer medium is in contact with a hot solid interface, which heats the medium into vapour, whereby the vapour travels through a conduit to a relatively cold solid interface, onto which the medium condensates into liquid. After returning into liquid phase, the medium returns to the hot solid interface for a next round in the cycle. The phase changes either absorb or release latent heat trapped in the medium thus resulting in effective heat transfer. The liquid may return to the hot solid interface by several different modes, such as gravity or capillary action. In the present context, the term heat pipe cycle is meant to be independent from the mode of return thus covering gravity and capillary action.

The heat pipe cycle takes place in the flow cavity 130 with the evaporation phase occurring at the end of the flow cavity 130 being initially heated by the heat source 200. For illustrative purposes, FIGURE 2 shows an approximated division between an evaporation zone 131, in which the heat transfer fluid is evaporated during the heat pipe cycle, and a condensation zone 132, in which the heat transfer fluid is returned to liquid form having transferred heat to the heat dissipation section 120. Similarly FIGURE 2 shows a sketched identification of a mounting zone 141 on the closing element 140 for receiving the heat source 200. The heat source 200 may be any electrical or optical component generating heat in a quantity which requires effective cooling, such as a microprocessor, LED, or IGBT module. With the closing element 140 attached to the block 110 the mounting zone 141 and the evaporation zone 131 are aligned. The closing element 140 may be attached to the block 110 by welding, laser welding, friction stir welding, brazing, or any other possible joining method known in the art. A particularly suitable method of joining the closing element 140 to the block 110 is shrink-fitting. The closing element 140 may be attached to the block 110 with any combination of the above. Accordingly, also the heat dissipation section 120 and the condensation zone 132 are aligned. There can be an additional layer of sealing material, glue, O-ring, etc. between the base structural element and the closing element. To facilitate an effective heat pipe cycle, the heat dissipation apparatus is preferably mounted in a generally vertical orientation, wherein the condensation zone 132 is above the evaporation zone 131.

In practice, the heat originating from the heat source 200 creates a hot spot in the flow cavity 130 identified as the evaporation zone 131. Conversely, the heat dissipating ability of the heat dissipation section 120 creates a relatively cool area identified as the condensation zone 132, where there is a dew point for the heat transfer fluid. In other words the heat dissipation section 120 forms the condensation zone 132. These zones 131, 132 are distinguished from each other based on the behaviour of the heat transfer fluid affected by the relative temperature differences between the zones 131, 132. The location and shape of the zones 131, 132 may vary during operation. As will transpire here after, the zones 131, 132 may also be spaced apart from each other so as to transfer heat between the heat source 200 and the heat dissipation section 120. Indeed, the mounting zone 141 may be spaced apart from the heat dissipation section 120 to achieve the lateral heat transfer. The mounting zone 141 and dissipation section 120, and therefore the evaporation and condensation zones 131, 132, may lie at the opposing ends of the block 110.

In the example of FIGURES 1 and 2 the heat dissipation section 120 is provided on a side of the block 110 opposing the heat source 200. The heat dissipation section 120 may be a separate component attached to the block 110, the heat dissipation section 120 may be produced as an integral feature in the same additive manufacturing stage as the block 110, or, as illustrated, the fins 121 of the heat dissipation section 120 may be attached to the block 110. Suitable attachment methods include welding, shrink-fitting, laser welding, friction stir welding, brazing, press fitting, skiving, and any combination of the above. The heat dissipation section 120 may extend across the entire width and length of the block 110 or, as shown in the other illustrated embodiments, the heat dissipation section 120 may be deviated from the evaporation zone 131.

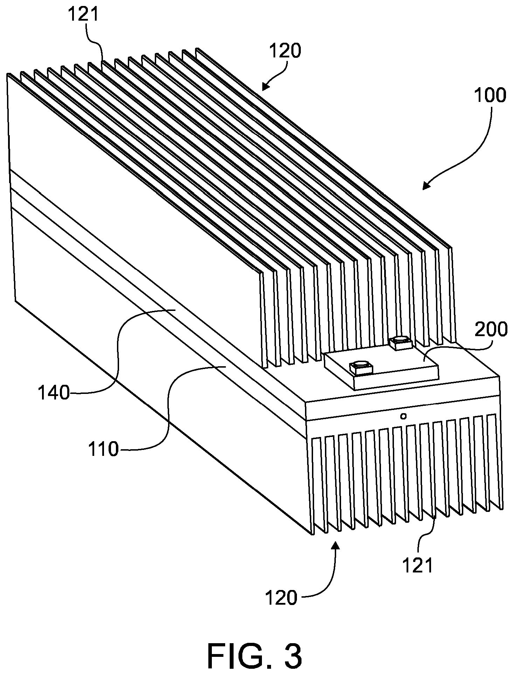

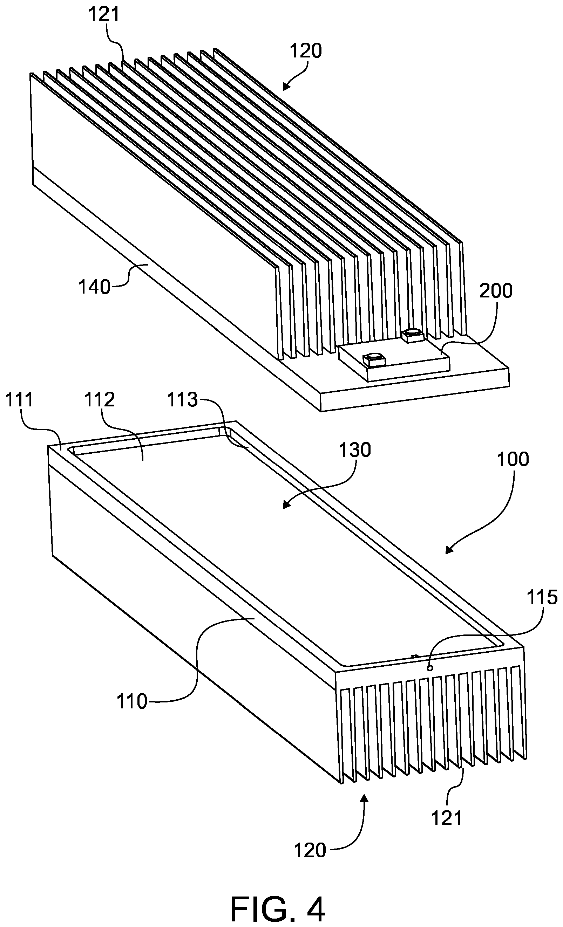

FIGURES 3 and 4 show a variant of the embodiment of FIGURES 1 and 2, wherein the closing element 140 is also provided with a heat dissipation section 120 for intensified dissipation. The heat dissipation section 120 on the closing element 140 may be produced by attaching, e.g. welding, individual fins 121 onto the closing element or by producing the fins 121 in the same additive manufacturing step as the rest of the closing element 140. Excess fins, if any, may then be removed by milling, for example, to create a mounting zone on the closing element 140 for the heat source 200. The multi-heat source embodiment could include more than two heat sources which could be arranged differently on the closing element, such as on the opposite ends over the length of the closing element 140.

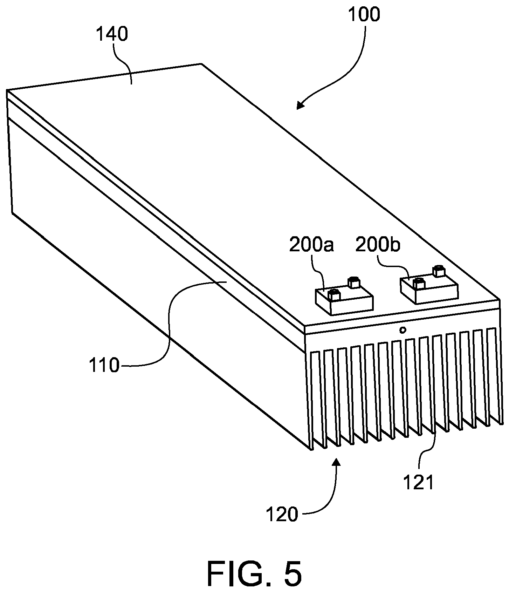

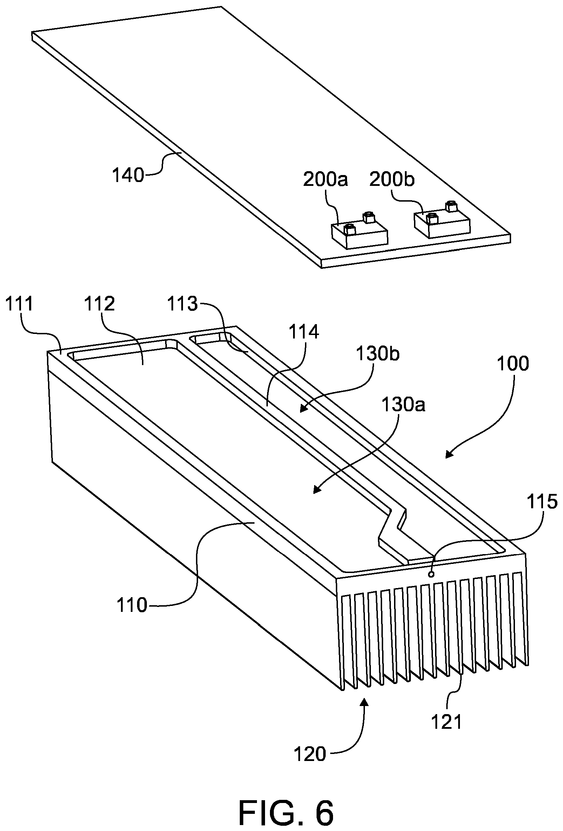

FIGURES 5 and 6 show a further variant of the embodiment of FIGURES 1 and 2, wherein a wider heat dissipation apparatus 100 is produced to assume several heat sources 200. According to the illustrated embodiment the heat dissipation apparatus 100 accommodates two heat sources, namely a first heat source 200a and a second heat source 200b mounted adjacent to one another on the closing element 140. While the flow cavity 130 could also be similarly widened, the embodiment of FIGURES 5 and 6 features a further development, in which the flow cavity 130 is split into several flow cavities to reflect the several heat sources 200. According to the illustrated embodiment the block 110 contains two flow cavities, namely a first flow cavity 130a and a second flow cavity 130b. The two flow cavities 130a, 130b are separated by an intermediate wall 114 there between. The intermediate wall 144 may be formed by the base material of the block 110 extending between opposing ends of the block along the length or width thereof. The flow cavities 130a, 130b may be different from one another. As illustrated in FIGURES 5 and 6, the first flow cavity 130a may be wider than the second flow cavity 130b. More specifically, the condensation zone of first flow cavity 130a may be wider than that of the second flow cavity 130b. The difference in width may be achieved with a meandering intermediate wall 114. By varying the width of the flow cavity, different proportions of the total dissipation capacity of the heat dissipation apparatus 100 may be assigned to the different heat sources 200a, 200b being cooled. Naturally, the block 110 could enclose more than two flow cavities.

Alternatively or additionally, the embodiment of FIGURES 5 and 6 could be combined with that of FIGURES 3 and 4 by including two heat dissipation sections 120.

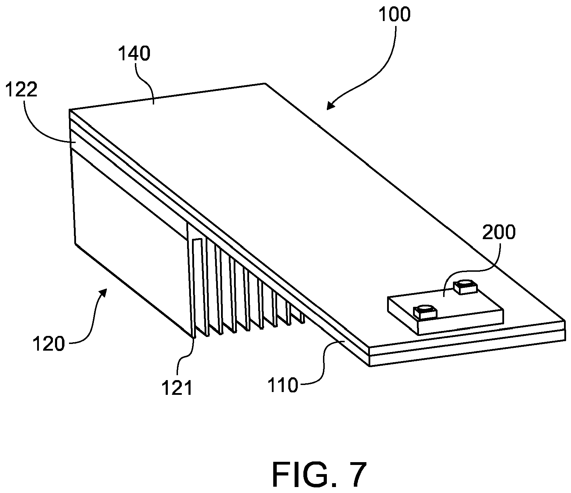

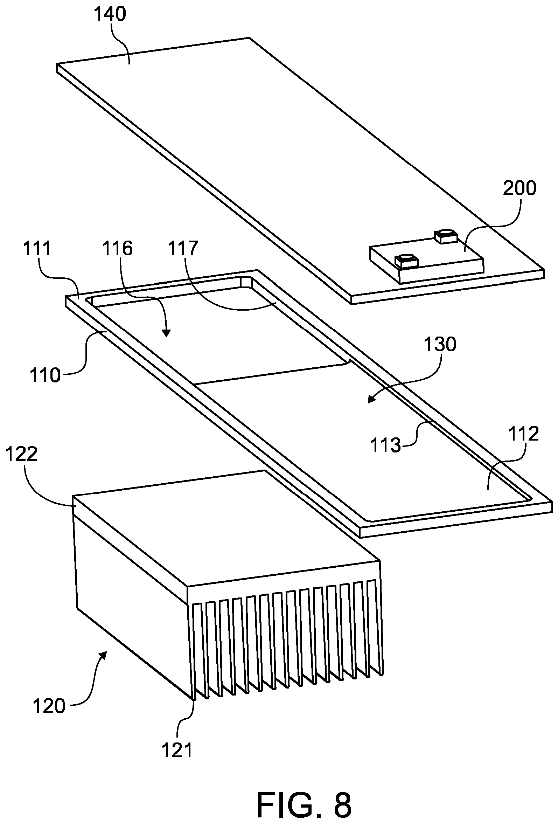

FIGURES 7 and 8 show yet a further variant of the embodiment of FIGURES 1 and 2, wherein the heat dissipation section 120 extends only across a portion of the length of the block 110 and wherein the heat dissipation section 120 is provided to the block 110 through a base 122. In the embodiment of FIGURES 7 and 8 the heat dissipation section 120 includes a base 122 from which the fins 121 extend. The heat dissipation section 120 may therefore be produced as a separate component from the block 110. The heat dissipation section 120, for example, be extruded, cast, die casted, forged, or produced with another additive manufacturing method. For accepting the heat dissipation section 120 the block 110 features an opening 116 formed by an edge 117 produced through the depth of the block 110. In the illustrated embodiment the opening 116 is provided to an end opposing the mounting zone for the heat source 200. The heat dissipation section 120 may be attached to the block 110 with an interference fit, a weld, or an affixer (not illustrated). The opening 116 may not extend across the length of the block 110, whereby the opening 116 may transition into the recess 112, which populates part of the length of the block 110. The recess 112. Depending on the installation depth of the heat dissipation section 120 the depth of the flow cavity 130 may vary between the recess 112 and opening 116. Further variance of the depth the flow cavity 130 may be provided with a recess produced to the closing element 140.

The embodiment of FIGURES 1 and 2 could alternatively be varied with only either of the variations of FIGURES 7 and 8, namely only a shorter heat dissipation section 120 or only with the connection construction between the heat dissipation section 120 and the base 110. Alternatively or additionally, the embodiment of FIGURES 7 and 8 could be combined with that of FIGURES 3 and 4 and/or FIGURES 5 and 6 by including two heat dissipation sections 120 and/or several heat sources 200a, 200b and/or several flow cavities 130a, 130b.

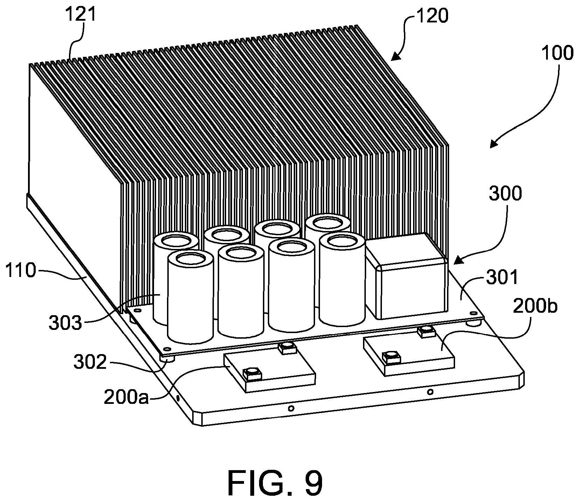

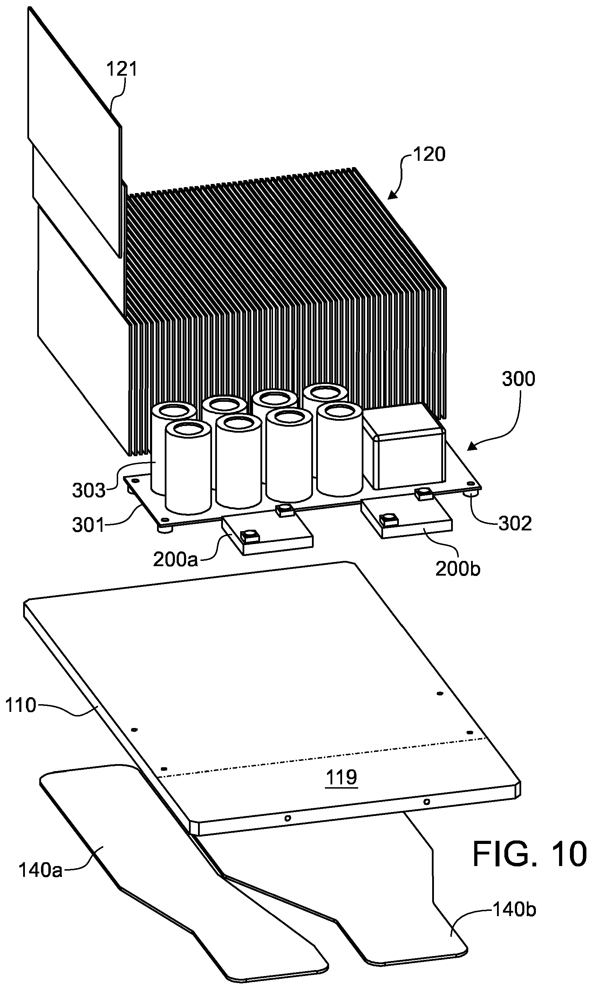

FIGURES 9 to 12 show a further embodiment which includes several variations from the embodiments of FIGURES 1 and 2, 3 and 4, 5 and 6, and 7 and 8. Unlike previously described embodiments, wherein the heat source 200 is mounted indirectly onto the block 110 through the closing element 140, the heat source or heat sources 200a, 200b is/are mounted directly onto the block 110 according to the embodiment of FIGURES 9 to 12. As shown in FIGURE 10, the heat sources 200a, 200b are mounted to one end of the block 100 in an area sketched as a mounting zone 119. The heat sources 200a, 200b may be mounted onto the block 110 by using an adhesive or affixers penetrating the component, clamps or other external suspending contraptions, soldering, brazing, etc. Heat conducting paste is preferably applied under the heat source. The mounting zone 119 may be selected somewhat arbitrarily but in the illustrated example the heat sources 200a, 200b have been mounted to one end of the block 110 is as to reserve enough space for a heat dissipation section 120 and optional additional componentry 300. The heat sources 200a, 200b, the heat dissipation section 120, and the additional componentry 300 are all provided to the same side of the block 110, whereas the flow cavity or flow cavities 130a, 130b are closed by closing elements 140a, 140b provided on the opposite side. The heat dissipation section 120 may be provided to the block 110 by attaching the fins 121 to the block individually by welding, for example. Alternatively, and similarly to the embodiments of FIGURES 1 to 6, the heat dissipation section 120 may be produced as an integral part of the block 110 by producing it in the same additive manufacturing step as the rest of the block 110 or the heat dissipation section 120 may be attached as a separate component as shown in the embodiment of FIGURES 7 and 8.

As indicated above, the additional componentry 300 is optional. The additional componentry 300 may for example include the circuitry required to control the heat source 200. FIGURES 9 to 12 illustrated an exemplary construction, wherein electrical components 303 may be, for example, surface mounted on a circuit board 301 which, in turn, is mounted to the block 110 through isolating feet 302.The isolating feet 302 are preferably configured to raise the circuit board 301 off the block 110 and/or made from a poorly conductive material. A practical example of such an application would be a power source including two power electronics components, which require extra cooling, as the heat sources 200a, 200b and control componentry, which may not require extra cooling, as the additional componentry 300, wherein all components, 200a, 200b, 303 may be mounted on a same carrying block 100 by transferring the heat of the power electronics 200a, 200b past the control componentry 303 for dissipation with the heat dissipation section 120.

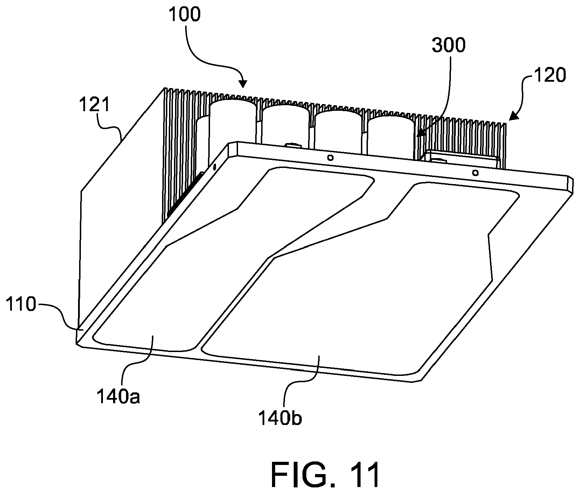

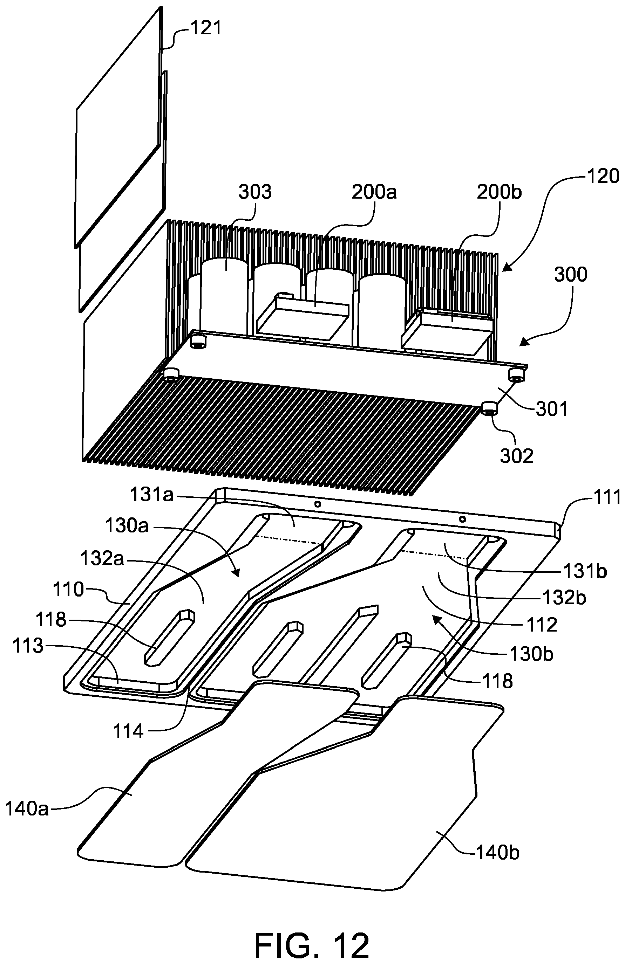

FIGURES 11 and 12 show the opposing side to the mounting side of the heat dissipation apparatus 100. Similarly to the previous embodiments, the flow cavity 130 is formed as a recess 112 to the block 110. The illustrated embodiment is designed for cooling two components which produce different amounts of heat, wherein the first heat source 200a is expected to produce much less heat than the second heat source 200b. Accordingly, the first flow cavity 130a is designed as smaller, particularly narrower, than the second flow cavity 130b so as to assign more dissipation capacity for the second heat source 200b. As with the embodiment of FIGURES 5 and 6, the flow cavities 130a, 130b of the embodiments of FIGURES 9 to 12 may be shaped to meander for enabling mounting the heat sources 200a, 200b to the central area of the mounting zone 119 while exploiting the fill width of the block 110 for the heat dissipation section 120. Indeed, the evaporation zones 131a, 131b may be offset from the condensation zones 132a, 132b along the length and width of the flow cavity. The relatively wide flow cavities 130a, 130b may be further split into sub-branches with intermediate structures provided inside the flow cavities 130a, 130b. The individual flow cavities 130a, 130b may be split into sub-branches with isthmuses 118 which may be provided with the base material of the block 110 similarly to the intermediate wall 114 dividing the flow cavities into two. In the illustrated example the first relatively narrow flow cavity 130a is divided into two sub-branches with one isthmus 118 and the second relatively wide flow cavity 130b is divided into four sub-branches with three isthmuses 118. The isthmus 118 may be advantageous in providing for a counterpart for welding or otherwise attaching the closing element 140 to the block 110. Additionally, the isthmus 118 will make the structure more rigid, which is advantageous in preventing unwanted audible emissions caused by the thermal cycle occurring inside the flow cavity. Additionally or alternatively, the division into sub-branches may be used to modify or optimize the flow dynamics inside the flow cavity.

The flow cavities 130a, 130b are closed with closing elements 140a, 140b which in the illustrated embodiment take the form of simple plates shaped to match the geometry of the flow cavities 130a, 130b. To enable flush installation there is a small embedding in the bottom surface of the block 110 to receive the closing elements 140a, 140b. The closing elements 140a, 140b of the present or other embodiments could be provided with more functionalities. The closing elements could, for example, include an additional heat dissipation section or inlets and/outlets for an external source of heat transfer medium.

As is shown in FIGURES 9 and 10 the block 110 is made relatively wide so as to accommodate several heat sources 200a, 200b. The embodiment could be varied by widening it further to accommodate more than two heat sources or narrowing it to accept only one heat source (not illustrated in the FIGURES). It should also be understood that the heat dissipation apparatus may include one heat source per flow cavity, several heat sources per flow cavity, or several flow cavities per heat source. Alternatively, the shape of the block 110 could be varied by placing the heat source(s) and the additional componentry parallel to each other adjacent to the heat dissipation section 120 (not illustrated in the FIGURES). Additionally or alternatively, the additional componentry 300 could be mounted on one or more of the closing elements (not illustrated in the FIGURES).

The above described embodiments have been discussed with reference to particular constructions which are illustrated as stand-alone devices. The described principles could, however, alternatively be applied and integrated to larger entities. The heat source could be, for example, a power electronic module or component used in an electrical system of an industrial host apparatus, such as an AC drive, electric vehicle charging station, or a LED luminaire. Such power electronic modules and components include IGBT modules, high power LED modules, high power RF components or any other heat generating components know in the art. The closing element or block could be an integral part of the host apparatus, such as part of the outer shell of the enclosure or cabinet. Take the embodiment of FIGURES 7 and 8 as an example. The block 110 could be a section of an enclosure wall which is provided with a heat source 200 on the inside through the closing element 140 and with a heat dissipation section 120 on the outside through the base 122 and opening 116. As may be understood, the heat dissipation section 120 may be placed relatively far away from the heat source 200, which is possible due to the novel design of the flow cavity 130. In addition, the heat dissipation section 120 may be located on the opposite side of the block 110 than the heat source 200 thus increasing the design flexibility of the heat dissipating apparatus 100.

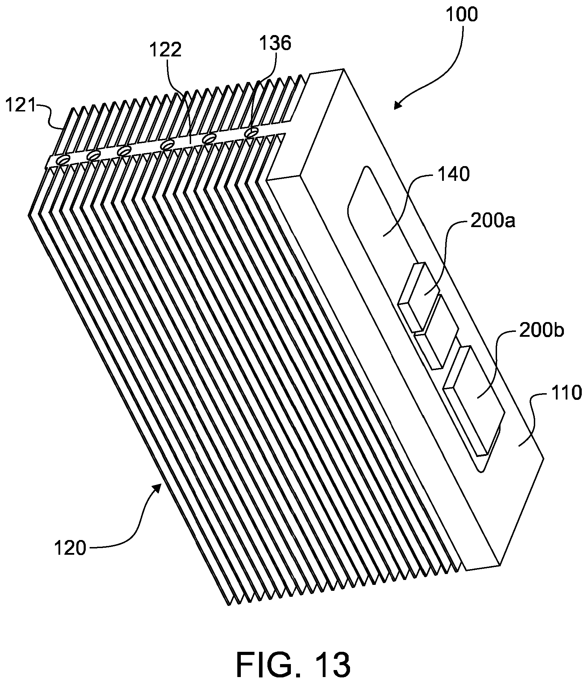

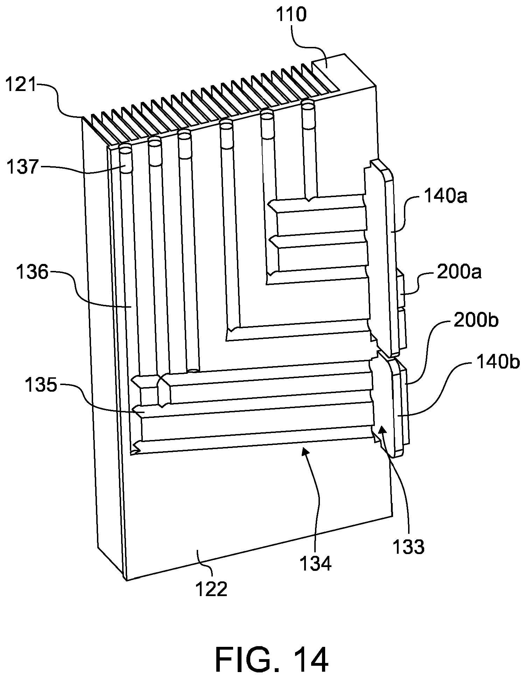

The embodiments shown in FIGURES 1 to 12 show a generally planar block 110 with the heat dissipation section 120 extending from the block 110 in a generally orthogonal orientation. As such, the flow cavity 130 formed into the block 110 is used to convey and spread the heat of the heat source 200 two-dimensionally to and across the heat dissipation section 120. However, a variant of the head spreading concept may also be foreseen, wherein the heat dissipation section 120 is provided to the block 110 through a base 122 which extends in a generally orthogonal orientation in respect to the block 110. Such a variant of the present novel heat dissipation apparatus concept is shown in FIGURES 13 and 14.

The heat dissipation apparatus 100 according to the modified embodiment has a block 110. The heat dissipation section 120 has a base 122, which extends orthogonally from or at least in a non-parallel orientation in respect to the block 110, and fins 121 extending conventionally from the base 122. The block 110 and base 120 enclose a flow cavity 130 which has two sections conveying and spreading heat three-dimensionally across the block 110 and base 1200 which extend in a non-parallel manner in respect to each other. As shown in the partially sectioned view of FIGURE 14, the section 133 of the flow channel 130, which is provided to the block 110 and which is closest to the heat source 200, has a generally flat and rotationally non-symmetrical cross-sectional shape. In the present context that section of the flow channel 130 is referred to as the proximal section 133. The proximal section 133 of the flow channel 130 of the heat dissipation apparatus 100 of FIGURES 13 and 14 may have a straight single path design as shown in FIGURES 2 and 4, a divided and varying shape as shown in FIGURE 6, a divided, varying and branched design shown in FIGURE 12, or any foreseeable combination or variant thereof. In the example of FIGURES 13 and 14 the heat source 200 has two components 200a, 200b attached to the block 110 through respective and distinct closing elements 140a, 140b bringing the heat sources 200a, 200b into conductive contact with the proximal section 133 of the flow cavity 130.

The second section of the flow cavity 130 is provided to the base 122 of the heat dissipation section 120 and is referred to as the distal section 134 to reflect the distal relationship with the heat source 200 compared to the proximal section 133. The purpose of the distal section 134 of the flow cavity 130 is to receive heat from the proximal section 133 and to convey the heat to the fins 121. Heat transfer may be achieved according to the heat pipe principle explained above. To spread the effectively across the base 122, the distal section 133 may be made up by a network of interconnected sub-cavities as shown in FIGURE 14 or a flat, rotationally non-symmetrical sub-cavity similar to the proximal section 133 (not illustrated in the FIGURES). A network of interconnected sub-cavities, is however, preferred due to ease of manufacture as a rotationally non-symmetrical sub-cavity could require assembly of the heat dissipation apparatus from two milled halves. The network of interconnected sub-cavities features a number of stems 135 extending from the proximal section 133 in a transversal orientation in respect thereto. In the illustrated embodiment the distal section 134 has seven such stems 135. The stems 135 convey and spread the heat across the base 122 away from the block 110.

The distal section 134 also has a number of branches 136 that extend in a parallel orientation in respect to the fins 121. This direction may practically be the extrusion direction of the heat dissipation section 120, whereby the branches 136 may be produced upon extrusion or machined subsequently. The branches 136 of FIGURE 14 have been drilled out after extrusion of the heat dissipation section 120. Accordingly, the branches 136 are blind holes that do not extend through the base 122. The heat dissipation section 120 may be produced in the same additive manufacturing step as the block 110 or separately and then joined by affixers, interlocking shapes, welding, or another foreseeable coupling method. The branches 136, which may run in a mutually parallel fashion, may be connected to one or more stems 135 which, too, run in a mutually parallel fashion. For example, the distal section 134 may have one single branch 136 (shown in the middle) having an individual stem 135 connecting it to the proximal section 133, a set of two branches (shown on the right) having three stems connecting them to the proximal section 133, and a set of three branches (shown on the left) having three stems connecting them to the proximal section 133. Some branches 136 may receive the heat transfer fluid from several stems 135. Accordingly, a given branch 136 may intersect with one or more stems 135. The stems 135 may be drilled through the proximal section 133 to connect the branches 136 to the proximal section 133 and, optionally, to each other. Accordingly, a network of sub-cavities may be achieved. The network of sub-cavities of the distal section 134 of the flow cavity 130 may be closed with plugs 137 provided to the ends of the branches 136.

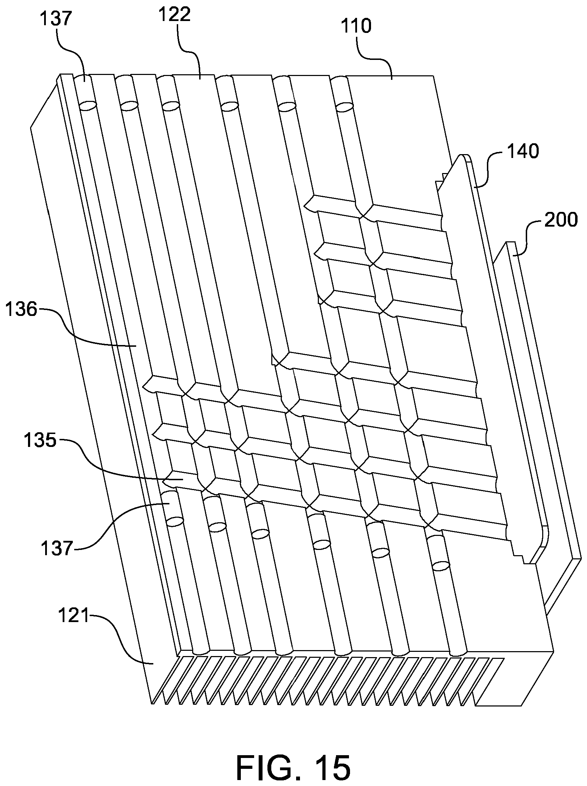

FIGURE 15 shows a variant of that according to FIGURES 13 and 14, wherein the branches 136 of the distal section 134 of the flow cavity 130 are not blind but extend through the base 122 of the heat dissipation section 120. Such a configuration may be produced by providing the branches 136 with appropriate extrusion tools during the additive manufacturing step of the heat dissipation section 120. Naturally, it is also possible to drill out such branches 136. Accordingly, both ends of the branches 136 may be closed with plugs 137. As indicated, the embodiment FIGURE 15 has a modified number of stems 135 and branches 135. The embodiment of FIGURE 15 shows a further modification in that the heat source 200 is connected to the closing element 140 through an additional mounting plate.

Further variants of the three-dimensional embodiment are foreseeable. For example, the heat dissipation apparatus 100 could comprise several such units as shown in FIGURES 13 to 15 arranged in parallel, series, or both parallel and series, to provide for an effective cooling solution to a host of heat sources. For example, the excessive heat generating components of an AC drive could be cooled by providing three units as shown FIGURES 13 and 14 or 15 in parallel to receive the three IGBT components of the three phases of the frequency converter. The three units could be assembled from three distinct apparatuses or produced as integral components by manufacturing them in the same additive manufacturing stage, e.g. by extrusion. The proximal sections of the flow cavities of these units could be in a flowing connection with respect to each other so as to share the cooling resources of the heat dissipation apparatus across the heat sources. Any such embodiment could be supplemented with the floating circuit board setup shown in FIGURES 9 to 12.

The heat dissipation could be promoted by providing a forced air flow through the heat dissipation section with a fan, for example.

The effectiveness of the heat pipe cycle may be improved by providing a porous or fibrous material inside the flow cavity for optimizing the heat transfer fluid distribution. In other words, the flow cavity may comprise a wick. The inner surface of the flow cavity may additionally or additionally be equipped with a ceramic coating, e.g. a thermal spray coating, for more effective evaporation and/or condensation of the heat transfer fluid.

While the double sided heat dissipation section shown in FIGURES 14 to 15 is preferred, the fins 121 could alternatively be provided to only one side of the base 122.

While the illustrated embodiments involve a generally planar design, the heat dissipation apparatus could alternatively be designed as more three-dimensional with the body including more than two faces for heat sources. According to one foreseeable embodiment, the body could have a generally polyhedronal shape. An example would be a body having a triangular cross-section, wherein the body could extend along an axis of elongation with three faces for receiving a heat source and/or a dissipation section. Naturally, more than three faces are foreseeable. Other examples include hexadronal, cubical, octahedronal and rhombicuboctahedronal shapes.

Further, the heat dissipation apparatus may include heat sources provided to both sides of the block. Let us take the embodiment shown in FIGURE 7 for example. Heat sources could be provided on both sides of the block 110, i.e. on the side opposing the heat dissipation section 120 as shown in FIGURE 7 but also on the side of the heat dissipation section 120. The additional heat source (not shown) may be attached directly or indirectly to the block 110.

The heat sources shown in the illustrated embodiments fit within the closing elements. The heat sources could alternatively extend past the closing element to overlay with the block. Accordingly, the closing element and the block both may comprise a shared mounting zone for receiving thereto the heat source.

It is to be understood that the embodiments of the invention disclosed are not limited to the particular structures, process steps, or materials disclosed herein, but are extended to equivalents thereof as would be recognized by those ordinarily skilled in the relevant arts. It should also be understood that terminology employed herein is used for the purpose of describing particular embodiments only and is not intended to be limiting.

Reference throughout this specification to "one embodiment" or "an embodiment" means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment.

As used herein, a plurality of items, structural elements, compositional elements, and/or materials may be presented in a common list for convenience. However, these lists should be construed as though each member of the list is individually identified as a separate and unique member. Thus, no individual member of such list should be construed as a de facto equivalent of any other member of the same list solely based on their presentation in a common group without indications to the contrary. In addition, various embodiments and example of the present invention may be referred to herein along with alternatives for the various components thereof. It is understood that such embodiments, examples, and alternatives are not to be construed as de facto equivalents of one another, but are to be considered as separate and autonomous representations of the present invention.

Furthermore, the described features, structures, or characteristics may be combined in any suitable manner in one or more embodiments. In the following description, numerous specific details are provided, such as examples of lengths, widths, shapes, etc., to provide a thorough understanding of embodiments of the invention. One skilled in the relevant art will recognize, however, that the invention can be practiced without one or more of the specific details, or with other methods, components, materials, etc. In other instances, well-known structures, materials, or operations are not shown or described in detail to avoid obscuring aspects of the invention.

While the forgoing examples are illustrative of the principles of the present invention in one or more particular applications, it is not intended that the invention be limited, except as by the claims set forth below.

### REFERENCE SIGNS LIST

| No. | Feature | No. | Feature |
|---|---|---|---|
| 100 | heat dissipation apparatus | 131 | evaporation zone |
| 110 | block | 132 | condensation zone |
| 111 | peripheral edge | 133 | proximal section |
| 112 | recess | 134 | distal section |
| 113 | transition | 135 | stem |
| 114 | intermediate wall | 136 | branch |
| 115 | port | 137 | plug |
| 116 | opening | 140 | closing element |
| 117 | opening edge | 141 | mounting zone |
| 118 | isthmus | 200 | heat source |
| 119 | mounting zone | 300 | additional componentry |
| 120 | heat dissipation section | 301 | board |
| 121 | fin | 302 | isolating foot |
| 122 | base | 303 | component |
| 130 | flow cavity | | |

## Claims

1. A heat dissipation apparatus (100) comprising:
- a block (110);
- a plurality closed flow cavities (130a, 130b), which:
∘ are formed, at least in part, into the block (110),
∘ are configured to perform a heat pipe cycle, when provided with a phase change heat transfer fluid and heat from a heat source (200),
∘ have, at least in part, a rotationally non-symmetrical cross-sectional shape, wherein the rotationally non-symmetrical shape of the flow cavity (130) has a:
▪ length (L) in one Cartesian dimension;
▪ width (W) in a second Cartesian dimension, and
▪ depth (D) in third Cartesian dimension,
wherein the length (L) and width (W) are both at least twice as large as the depth (D),
∘ are spaced apart by an intermediate wall (114) of the block (110) between said flow cavities (130a, 130b), and which flow cavities (130a, 130b)
∘ have different widths (W) for assigning different heat dissipating resources for different heat sources (200a, 200b),
- at least one heat dissipation section (120), which comprises a plurality of fins (121) attached or formed to and extending from the block (110), and
- the heat dissipation apparatus (100) comprises a closing element (140), which is attached to the block (110) for closing the flow cavity (130),
**characterized in that**:
- the heat dissipation apparatus (100) comprises a mounting zone (141) on the closing element (140) or the block (110) or on the closing element (140) and the block (110) for receiving thereto the heat source (200), which mounting zone (119, 141) is configured to receive a plurality of such heat sources (200a, 200b) aligned with the respective plurality of flow cavities (130a, 130b), and **in that**
- the plurality fins (121) extend from the block (110) in the third Cartesian dimension.

2. The heat dissipation apparatus (100) according to claim 1, wherein the flow cavity (130) has, at least in part, a generally quadrilateral cross-sectional shape.

3. The heat dissipation apparatus (100) according to claim 1 or 2, wherein the flow cavity (130) comprises a proximal section (133), which is closest to a mounting point for the heat source (200), wherein the proximal section (133) has the rotationally non-symmetrical cross-sectional shape.

4. The heat dissipation apparatus (100) according to claim 3, wherein:
- the heat dissipation section (120) comprises a base (122) and a plurality of fins (121) extending from the base (122),
- the base (122) extends from the block (110),
- the flow cavity (130) comprises a distal section (134), which is connected to the proximal section (133), and wherein
- the distal section (134) is provided to the base (122) and configured to spread the heat from the proximal section (133) along the base (122).

5. The heat dissipation apparatus (100) according to claim 4, wherein the distal section (134) comprises a network of interconnected sub-cavities which is connected to the proximal section (133).

6. The heat dissipation apparatus (100) according to any one of the preceding claims, wherein the rotationally non-symmetrical cross-sectional shape extends more in one dimension than in an orthogonal other dimension by one order of magnitude or more.

7. The heat dissipation apparatus (100) according to any one of the preceding claims, wherein the length (L) and width (W) are both at least five times or more than five times the depth (D), preferably ten times or more than ten times the depth (D).

8. The heat dissipation apparatus (100) according to any one of the preceding claims, wherein the rotationally non-symmetrical section of the flow cavity (130):
- comprises an evaporation zone (131);
- comprises a condensation zone (132) distinguished or spaced apart from the evaporation zone (131), and
- is configured to perform the heat pipe cycle between the evaporation zone (131) and the condensation zone (132).

9. The heat dissipation apparatus (100) according to claim 8, wherein the block (110) is configured to receive the heat source (200) directly or indirectly at the evaporation zone (131).

10. The heat dissipation apparatus (100) according to claim 8 or 9, wherein the heat dissipation section (120) forms the condensation zone (132) by providing a dew point for the heat transfer fluid.

11. The heat dissipation apparatus (100) according to any one of the preceding claims, wherein the rotationally non-symmetrical section of the flow cavity (130) or one or more of the flow cavities (130a, 130b) comprises an isthmus (118) for dividing the flow cavity (130) into branches.

12. The heat dissipation apparatus (100) according to any one of the preceding claims, wherein the heat dissipation section (120) comprises a plurality of fins (121) attached, e.g. welded, to the block (110) or closing element (140) or both to the block (110) and closing element (140).

13. The heat dissipation apparatus (100) according to any one of the preceding claims, wherein the heat dissipation section (120) is spaced apart from the mounting zone (119, 141).

14. The heat dissipation apparatus (100) according to any one of the preceding claims, wherein the mounting zone (119, 141) is on the opposite side of the block (110) than the heat dissipation section (120).

## Patentansprüche

1. Wärmeableitungseinrichtung (100) umfassend:
- einen Block (110);
- eine Vielzahl geschlossener Strömungskammern (130a, 130b), welche:
- zumindest teilweise in den Block (110) geformt werden,
- dazu konfiguriert sind, einen Wärmerohrkreislauf durchzuführen, wenn sie mit einem flüssigen Phasenwechsel-Wärmeträger und Wärme von einer Wärmequelle (200) versehen sind.
- zumindest teilweise eine nicht rotationssymmetrische Querschnittsform aufweisen, wobei die nicht rotationssymmetrische Form der Strömungskammer (130) aufweist:
- eine Länge (L) in einer kartesischen Dimension;
- eine Breite (W) in einer zweiten kartesischen Dimension, und
- eine Tiefe (D) in dritter kartesischer Dimension,
wobei die Länge (L) und Breite (W) jeweils zumindest doppelt so groß wie die Tiefe (D) sind,
- durch eine Zwischenwand (114) des Blocks (110) zwischen den Strömungskammern (130a, 130b) voneinander beabstandet sind, und wobei die Strömungskammern (130a, 130b)
- unterschiedliche Breiten (W) zum Zuweisen unterschiedlicher Wärmeableitungsressourcen für unterschiedliche Wärmequellen (200a, 200b) aufweisen,
- zumindest einen Wärmeableitungsabschnitt (120), welcher eine Vielzahl von Rippen (121) umfasst, welche an dem Block (110) befestigt oder geformt sind und sich von diesem erstrecken, und
- die Wärmeableitungseinrichtung (100) ein Verschlusselement (140) umfasst, welches an dem Block (110) befestigt ist, um die Strömungskammer (130) zu verschließen,
**dadurch gekennzeichnet, dass:**
- die Wärmeableitungseinrichtung (100) eine Montagezone (141) an dem Verschlusselement (140) oder an dem Block (110) oder an dem Verschlusselement (140) und dem Block (110) umfasst, um die Wärmequelle (200) darauf aufzunehmen, wobei die Montagezone (119 , 141) dazu konfiguriert ist, eine Vielzahl von solchen Wärmequellen (200a, 200b) aufzunehmen, welche mit der jeweiligen Vielzahl von Strömungskammern (130a, 130b) ausgerichtet sind, und dass
- die Vielzahl von Rippen (121) sich von dem Block (110) in der dritten kartesischen Dimension erstrecken.

2. Wärmeableitungseinrichtung (100) nach Anspruch 1, wobei die Strömungskammer (130) zumindest teilweise eine im Allgemeinen viereckige Querschnittsform aufweist.

3. Wärmeableitungseinrichtung (100) nach Anspruch 1 oder 2, wobei die Strömungskammer (130) einen proximalen Abschnitt (133) umfasst, welcher einem Montagepunkt für die Wärmequelle (200) am nächsten liegt, wobei der proximale Abschnitt (133) eine nicht rotationssymmetrische Querschnittsform aufweist.

4. Wärmeableitungseinrichtung (100) nach Anspruch 3, wobei:
- der Wärmeableitungsabschnitt (120) eine Basis (122) und eine Vielzahl von Rippen (121) umfasst, welche sich von der Basis (122) erstrecken,
- die Basis (122) sich von dem Block (110) erstreckt,
- die Strömungskammer (130) einen distalen Abschnitt (134) umfasst, welcher mit dem proximalen Abschnitt (133) verbunden ist, und wobei
- der distale Abschnitt (134) an der Basis (122) bereitgestellt und dazu konfiguriert ist, die Wärme von dem proximalen Abschnitt (133) entlang der Basis (122) zu verteilen.

5. Wärmeableitungseinrichtung (100) nach Anspruch 4, wobei der distale Abschnitt (134) ein Netzwerk von miteinander verbundenen Teilkammern umfasst, welches mit dem proximalen Abschnitt (133) verbunden ist.

6. Wärmeableitungseinrichtung (100) nach einem der vorstehenden Ansprüche, wobei die nicht rotationssymmetrische Querschnittsform sich in einer Dimension um zu eine Größenordnung stärker erstreckt als in der dazu orthogonalen anderen Dimension.

7. Wärmeableitungseinrichtung (100) nach einem der vorstehenden Ansprüche, wobei die Länge (L) und Breite (W) jeweils zumindest das Fünffache oder mehr als das Fünffache der Tiefe (D), bevorzugt das Zehnfache oder mehr als das Zehnfache der Tiefe (D) betragen.

8. Wärmeableitungseinrichtung (100) nach einem der vorstehenden Ansprüche, wobei der nicht rotationssymmetrische Abschnitt der Strömungskammer (130):
- eine Verdampfungszone (131) umfasst;
- eine Kondensationszone (132) umfasst, welche von der Verdampfungszone (131) unterschieden oder beabstandet ist, und
- dazu konfiguriert ist, den Wärmerohrkreislauf zwischen der Verdampfungszone (131) und der Kondensationszone (132) durchzuführen.

9. Wärmeableitungseinrichtung (100) nach Anspruch 8, wobei der Block (110) dazu konfiguriert ist, die Wärmequelle (200) direkt oder indirekt in der Verdampfungszone (131) aufzunehmen.

10. Wärmeableitungseinrichtung (100) nach Anspruch 8 oder 9, wobei der Wärmeableitungsabschnitt (120) die Kondensationszone (132) bildet, indem er einen Taupunkt für den flüssigen Wärmeträger bereitstellt.

11. Wärmeableitungseinrichtung (100) nach einem der vorstehenden Ansprüche, wobei der nicht rotationssymmetrische Abschnitt der Strömungskammer (130) oder einer oder mehrerer der Strömungskammern (130a, 130b) einen Isthmus (118) zum Aufteilen der Strömungskammer (130) in Zweige umfasst.

12. Wärmeableitungseinrichtung (100) nach einem der vorstehenden Ansprüche, wobei der Wärmeableitungsabschnitt (120) eine Vielzahl von Rippen (121) umfasst, welche an dem Block (110) oder dem Verschlusselement (140) oder sowohl an dem Block (110) und dem Verschlusselement (140) befestigt, z. B. angeschweißt sind.

13. Wärmeableitungseinrichtung (100) nach einem der vorstehenden Ansprüche, wobei der Wärmeableitungsabschnitt (120) von der Montagezone (119, 141) beabstandet ist.

14. Wärmeableitungseinrichtung (100) nach einem der vorstehenden Ansprüche, wobei sich die Montagezone (119, 141) auf der dem Wärmeableitungsabschnitt (120) gegenüberliegenden Seite des Blocks (110) befindet.

## Revendications

1. Appareil de dissipation de chaleur (100), comprenant :
- un bloc (110) ;
- une pluralité de cavités d'écoulement fermées (130a, 130b), qui :
- sont formées, au moins en partie, dans le bloc (110),
- sont configurées pour effectuer un cycle de caloduc, lorsqu'elles sont alimentées par un fluide caloporteur à changement de phase et par de la chaleur provenant d'une source de chaleur (200),
- présentent, au moins en partie, une forme de section transversale non symétrique en rotation, dans lequel la forme non symétrique en rotation de la cavité d'écoulement (130)présente :
- une longueur (L) dans une dimension cartésienne ;
- une largeur (W) dans une deuxième dimension cartésienne, et
- une profondeur (D) dans une troisième dimension cartésienne,
dans lequel la longueur (L) et la largeur (W) sont toutes deux au moins deux fois plus grandes que la profondeur (D),
- sont espacées par une paroi intermédiaire (114) du bloc (110) entre lesdites cavités d'écoulement (130a, 130b), et lesquelles cavités d'écoulement (130a, 130b)
- présentent des largeurs différentes (W) pour attribuer différentes ressources de dissipation de chaleur à différentes sources de chaleur (200a, 200b),
- au moins une section de dissipation de chaleur (120), qui comprend une pluralité d'ailettes (121) fixées ou formées sur et s'étendant à partir du bloc (110), et
- l'appareil de dissipation de chaleur (100) comprend un élément de fermeture (140), qui est fixé au bloc (110) pour fermer la cavité d'écoulement (130),
**caractérisé en ce que** :
- l'appareil de dissipation de chaleur (100) comprend une zone de montage (141) sur l'élément de fermeture (140) ou le bloc (110), ou sur l'élément de fermeture (140) et le bloc (110), destinée à recevoir la source de chaleur (200), laquelle zone de montage (119, 141) est configurée pour recevoir une pluralité de telles sources de chaleur (200a, 200b) alignées avec la pluralité respective de cavités d'écoulement (130a, 130b), et **en ce que**
- la pluralité d'ailettes (121) s'étendent à partir du bloc (110) dans la troisième dimension cartésienne.

2. Appareil de dissipation de chaleur (100) selon la revendication 1, dans lequel la cavité d'écoulement (130) présente, au moins en partie, une forme de section transversale généralement quadrilatérale.

3. Appareil de dissipation de chaleur (100) selon la revendication 1 ou 2, dans lequel la cavité d'écoulement (130) comprend une section proximale (133), qui est la plus proche d'un point de montage pour la source de chaleur (200), dans lequel la section proximale (133) présente une forme de section transversale non symétrique en rotation.

4. Appareil de dissipation de chaleur (100) selon la revendication 3, dans lequel :
- la section de dissipation de chaleur (120) comprend une base (122) et une pluralité d'ailettes (121) s'étendant à partir de la base (122),
- la base (122) s'étend à partir du bloc (110),
- la cavité d'écoulement (130) comprend une section distale (134), qui est reliée à la section proximale (133), et dans lequel
- la section distale (134) est fournie à la base (122) et configurée pour répartir la chaleur à partir de la section proximale (133) le long de la base (122).

5. Appareil de dissipation de chaleur (100) selon la revendication 4, dans lequel la section distale (134) comprend un réseau de sous-cavités interconnectées qui est connecté à la section proximale (133).

6. Appareil de dissipation de chaleur (100) selon l'une quelconque des revendications précédentes, dans lequel la forme de section transversale non symétrique en rotation s'étend davantage dans une dimension que dans une autre dimension orthogonale d'un ordre de grandeur ou plus.

7. Appareil de dissipation de chaleur (100) selon l'une quelconque des revendications précédentes, dans lequel la longueur (L) et la largeur (W) sont toutes deux au moins cinq fois ou plus de cinq fois la profondeur (D), de préférence dix fois ou plus de dix fois la profondeur (D).

8. Appareil de dissipation de chaleur (100) selon l'une quelconque des revendications précédentes, dans lequel la section non symétrique en rotation de la cavité d'écoulement (130) :
- comprend une zone d'évaporation (131) ;
- comprend une zone de condensation (132) distincte ou espacée de la zone d'évaporation (131), et
- est configurée pour effectuer le cycle de caloduc entre la zone d'évaporation (131) et la zone de condensation (132).

9. Appareil de dissipation de chaleur (100) selon la revendication 8, dans lequel le bloc (110) est configuré pour recevoir la source de chaleur (200) directement ou indirectement au niveau de la zone d'évaporation (131).

10. Appareil de dissipation de chaleur (100) selon la revendication 8 ou 9, dans lequel la section de dissipation de chaleur (120) forme la zone de condensation (132) en fournissant un point de rosée pour le fluide de transfert de chaleur.

11. Appareil de dissipation de chaleur (100) selon l'une quelconque des revendications précédentes, dans lequel la section non symétrique en rotation de la cavité d'écoulement (130) ou d'une ou plusieurs des cavités d'écoulement (130a, 130b) comprend un isthme (118) pour diviser la cavité d'écoulement (130) en branches.

12. Appareil de dissipation de chaleur (100) selon l'une quelconque des revendications précédentes, dans lequel la section de dissipation de chaleur (120) comprend une pluralité d'ailettes (121) fixées, par exemple soudées, au bloc (110) ou à l'élément de fermeture (140) ou à la fois au bloc (110) et à l'élément de fermeture (140).

13. Appareil de dissipation de chaleur (100) selon l'une quelconque des revendications précédentes, dans lequel la section de dissipation de chaleur (120) est espacée de la zone de montage (119, 141).

14. Appareil de dissipation de chaleur (100) selon l'une quelconque des revendications précédentes, dans lequel la zone de montage (119, 141) est du côté opposé du bloc (110) par rapport à la section de dissipation de chaleur (120).
